# EUROPÄISCHE PATENTSCHRIFT

(11) **EP 2 354 278 B1**
(45) Veröffentlichungstag und Bekanntmachung des Hinweises auf die Patenterteilung: **04.07.2012**
(21) Anmeldenummer: 11150764.6
(22) Anmeldetag: 12.01.2011
(51) Int. Cl.: C30B 13/20, C30B 13/26, C30B 13/30, C30B 13/32, C30B 29/06, H05B 6/24

(54) **Verfahren zur Herstellung eines Einkristalls aus Silizium unter Verwendung von geschmolzenem Granulat**
Method for producing a single crystal composed of silicon using molten granules
Procédé destiné à la fabrication d'un monocristal en silicium en utilisant des granulés fondus

(30) Priorität: 03.02.2010 DE 102010006724
(43) Veröffentlichungstag der Anmeldung: 10.08.2011
(73) Patentinhaber: Siltronic AG, 81737 München (DE)
(72) Erfinder: von Ammon, Wilfried, 5122, Hochburg (AT); Altmannshofer, Ludwig, 84323, Massing (DE)
(74) Vertreter: Staudacher, Wolfgang

(56) Entgegenhaltungen:
- EP-A1- 2 319 961
- DE-A1-102008 013 326

## Beschreibung

Gegenstand der Erfindung ist ein Verfahren zur Herstellung eines Einkristalls aus Silizium unter Verwendung von geschmolzenem Granulat. Das Verfahren umfasst das Erzeugen eines ersten Volumens aus geschmolzenem Silizium zwischen einem wachsenden Einkristall und dem unteren Ende eines am unteren Ende verschlossenen konischen Rohrs aus Silizium, das eine zentrale Öffnung einer sich drehenden Platte aus Silizium umschließt, unter die sich das Rohr erstreckt, mittels einer ersten Induktionsheizspule, die unter der Platte angeordnet ist;
das Erzeugen eines zweiten Volumens aus geschmolzenem Silizium mit Hilfe einer zweiten Induktionsheizspule, die über der Platte angeordnet ist;
das Schmelzen des unteren Endes des Rohrs in einem Ausmaß, dass eine Durchtrittsöffnung für das zweite Volumen von geschmolzenem Silizium geschaffen wird; und
das Kristallisieren von einkristallinem Silizium auf dem wachsenden Einkristall unter Verbrauch von geschmolzenem Silizium aus dem ersten und dem zweiten Volumen.

Zunächst wird ein Dünnhals ("neck"), dann ein konusförmig erweiterter Abschnitt des Einkristalls und schließlich ein zylindrischer Abschnitt des Einkristalls kristallisiert. Am Anfang des Verfahrens stammt das zum Kristallisieren benötigte geschmolzene Silizium von einem Impfkristall und vom unteren Ende des konischen Rohrs, das zu diesem Zweck geschmolzen wird. Im weiteren Verlauf des Verfahrens wird zum Kristallisieren benötigtes geschmolzenes Silizium auch erhalten, indem die obere Seite der Platte und die Innenwand des Rohrs mit Hilfe der zweiten Induktionsheizspule geschmolzen werden. Ein überwiegender Teil des zum Kristallisieren des Einkristalls benötigten geschmolzenen Siliziums wird erhalten, indem auf die Platte gefördertes Granulat mit Hilfe der zweiten Induktionsheizspule geschmolzen und als flüssiger Film durch das Rohr zum wachsenden Einkristall geleitet wird.

Das Verfahren unterscheidet sich vom Zonenziehen, das auch FZ-Verfahren ("floating zone method") genannt wird, im Wesentlichen dadurch, dass Granulat an Stelle eines polykristallinen Blocks geschmolzen wird, um den überwiegenden Teil des zum Wachsen des Einkristalls benötigten geschmolzenen Siliziums bereitzustellen, und dadurch, dass zum Schmelzen des Granulats und zum Steuern des Kristallisierens des Einkristalls jeweils eine eigene Induktionsheizspule ("inductor coil") eingesetzt wird.

Zu Beginn des Verfahrens wird das konische Rohr, das zu diesem Zeitpunkt an seinem unteren Ende verschlossen ist, mit Hilfe der, unter der Platte angeordneten ersten Induktionsheizspule angeschmolzen. Am unteren Ende des konischen Rohrs entsteht ein Tropfen aus geschmolzenem Silizium. Daran wird ein Impfkristall angesetzt. Anschließend wird der Impfkristall mit Hilfe der ersten Induktionsheizspule zu einem Dünnhals umkristallisiert, und das Volumen an geschmolzenem Silizium auf dem entstandenen Dünnhals zu einem ersten Volumen aus geschmolzenem Silizium vergrößert, indem nach und nach weiteres Silizium vom unteren Ende des Rohrs geschmolzen wird. Analog zum FZ-Verfahren wird auf dem Dünnhals ein versetzungsfreier konusförmig erweiterter Abschnitt des Einkristalls und schließlich ein zylindrischer Abschnitt des Einkristalls kristallisiert. Während des Kristallisierens des konusförmig erweiterten Abschnitts des Einkristalls oder bereits zuvor wird das untere Ende des konischen Rohrs in einem Ausmaß geschmolzen, dass am unteren Ende des Rohrs eine Durchtrittsöffnung für geschmolzenes Silizium geschaffen wird. Ab diesem Zeitpunkt kann ein zweites Volumen aus geschmolzenem Silizium an der Innenwand des Rohrs entlang und durch die Durchtrittsöffnung hindurch in das erste Volumen aus geschmolzenem Silizium fließen. Das zweite Volumen aus geschmolzenem Silizium wird mit Hilfe der zweiten Induktionsheizspule erzeugt.

Das Verfahren und Vorrichtungen, die zu dessen Durchführung geeignet sind, sind beispielsweise in der DE 102 04 178 A1 beschrieben.

In der DE 10 2008 013 326 A1 ist eine Induktionsheizspule beschrieben, die als zweite Induktionsheizspule des Verfahrens verwendet werden kann. Sie weist im Zentrum der unteren Seite hervorstehende Segmente auf, mit deren Hilfe der, durch das konische Rohr fließende Film aus geschmolzenem Silizium erhitzt und flüssig gehalten werden kann.

Bei der Durchführung des Verfahrens können störende Ereignisse auftreten, die die Ausbeute an Einkristallen, aus denen einkristalline Halbleiterscheiben gefertigt werden können, reduzieren. So können sich plötzlich Versetzungen bilden oder geschmolzenes Silizium fließt an der Seite des bis dahin gewachsenen Einkristalls ab.

Die Erfinder sind der Ursache solcher Störungen nachgegangen, wobei die vorliegende Erfindung entstanden ist. Aufgabe der Erfindung ist es, das Auftreten der geschilderten störenden Ereignisse zu reduzieren.

Gelöst wird die Aufgabe durch ein Verfahren zur Herstellung eines Einkristalls aus Silizium unter Verwendung von geschmolzenem Granulat, umfassend
das Erzeugen eines ersten Volumens aus geschmolzenem Silizium zwischen einem wachsenden Einkristall und dem unteren Ende eines am unteren Ende verschlossenen konischen Rohrs aus Silizium, das eine zentrale Öffnung einer sich drehenden Platte aus Silizium umschließt, unter die sich das Rohr erstreckt, mittels einer ersten Induktionsheizspule, die unter der Platte angeordnet ist;
das Erzeugen eines zweiten Volumens aus geschmolzenem Silizium mit Hilfe einer zweiten Induktionsheizspule, die über der Platte angeordnet ist;
das Schmelzen des unteren Endes des Rohrs in einem Ausmaß, dass eine Durchtrittsöffnung für das zweite Volumen von geschmolzenem Silizium geschaffen wird, wobei die Durchtrittsöffnung zu einem Zeitpunkt geschaffen wird, zu dem das zweite Volumen aus geschmolzenem Silizium noch nicht vorhanden oder kleiner als das doppelte Volumen des ersten Volumens aus geschmolzenem Silizium ist; und
das Kristallisieren von einkristallinem Silizium auf dem wachsenden Einkristall unter Verbrauch von geschmolzenem Silizium aus dem ersten und dem zweiten Volumen.

Als Ursache der störenden Ereignisse wurde eine zu hohe Belastung des wachsenden Einkristalls in Folge des Schaffens der Durchtrittsöffnung im konischen Rohr identifiziert. Der wachsende Einkristall wird belastet, wenn das zweite Volumen aus geschmolzenem Silizium mit dem Entstehen der Durchtrittsöffnung nahezu augenblicklich in das erste Volumen aus geschmolzenem Silizium fließt. Erfindungsgemäß wird diese Belastung begrenzt, indem die Durchtrittsöffnung zu einem Zeitpunkt geschaffen wird, zu dem das zweite Volumen aus geschmolzenem Silizium kleiner als das doppelte Volumen des ersten Volumens aus geschmolzenem Silizium ist. Wird das Verfahren mit dieser Maßgabe durchgeführt, werden die geschilderten störenden Ereignisse deutlich seltener.

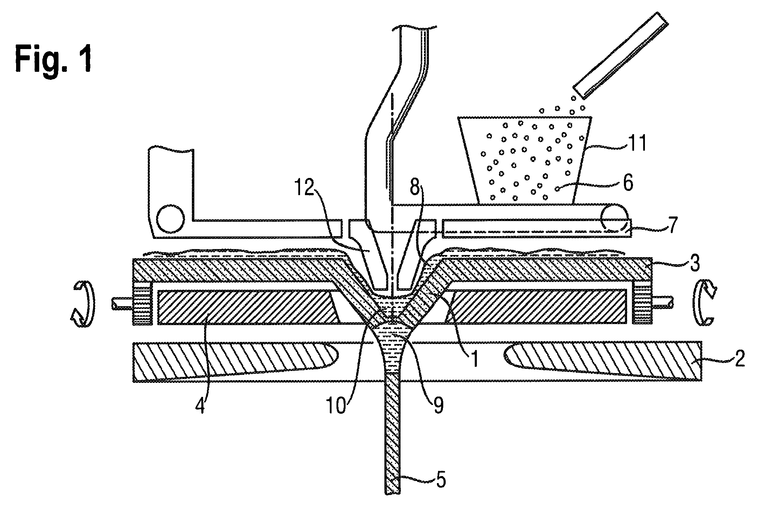

Die Erfindung wird nachfolgend an Hand von Figur 1 weiter erläutert. Figur 1 zeigt die Phase kurz bevor die Durchtrittsöffnung im konischen Rohr geschaffen wird.

Zu Beginn des Verfahrens wird das untere Ende des konischen Rohrs 1 mit Hilfe der ersten Induktionsheizspule 2 angeschmolzen, wobei ein Tropfen aus geschmolzenem Silizium entsteht. Die erste Induktionsheizspule und das konische Rohr sind in dieser Phase vorzugsweise so zueinander angeordnet, dass der Abstand zwischen dem Rand des Innenlochs der ersten Induktionsheizspule und dem Tropfen aus geschmolzenem Silizium möglichst gering ist. Der Abstand wird vorzugsweise verkürzt, indem die erste Induktionsheizspule aus einer koaxialen Anordnung zur Seite verschoben wird. Die auf den Tropfen und das untere Ende des Rohrs induktiv übertragene Energiedichte ist dann höher, als bei einer koaxialen Anordnung des konischen Rohrs und der ersten Induktionsheizspule. Zu einem späteren Zeitpunkt, insbesondere wenn der zylindrische Abschnitt des Einkristalls kristallisiert wird, ist die koaxiale Anordnung bevorzugt. Das konische Rohr 1 umschließt eine zentrale Öffnung einer sich drehenden Platte 3 aus Silizium und erstreckt sich unter die Platte. Die untere Seite der Platte wird mit Hilfe einer Kühlvorrichtung 4, die zwischen der Platte und der ersten Induktionsheizspule 2 angeordnet ist, gekühlt, damit die untere Seite der Platte 3 nicht geschmolzen wird. Die Kühlvorrichtung 4 kann auch als obere Schicht der ersten Induktionsheizspule 2 ausgebildet sein.

In den durch das Anschmelzen des unteren Endes des Rohrs entstandenen Tropfen aus geschmolzenem Silizium wird von unten ein einkristalliner Impfkristall getaucht. Daraufhin wird der Impfkristall mit Hilfe der ersten Induktionsheizspule 2 zu einem Dünnhals 5 umkristallisiert, um Versetzungen, die sich beim in Kontakt Bringen des Impfkristalls mit dem Tropfen bilden, aus dem Kristallgitter zu lenken. Im weiteren Verlauf des Verfahrens wird der vertikale Abstand zwischen dem Dünnhals 5 und dem Ende des konischen Rohrs 1 fortschreitend vergrößert, und erst ein nicht dargestellte konusförmig erweiterter Abschnitt des Einkristalls auf dem Dünnhals 5 und anschließend ein ebenfalls nicht dargestellter zylindrischer Abschnitt des Einkristalls auf dem konusförmig erweiterten Abschnitt kristallisiert.

Der Einkristall enthält vorzugsweise mindestens einen Dotierstoff, der dem geschmolzenem Silizium, beispielsweise in Form von Dotiergas, hinzugefügt wird oder im Silizium vor dem Schmelzen enthalten ist.

Das zum Kristallisieren benötigte geschmolzene Silizium stammt anfänglich vom Impfkristall und vom unteren Ende des konischen Rohrs, später von der oberen Seite der Platte, von der Innenwand des Rohrs und, insbesondere während des Kristallisierens des zylindrischen Abschnitts des Einkristalls, von auf die Platte 3 gefördertem Granulat 6, das mittels einer zweiten Induktionsheizspule 7, die über der Platte 3 angeordnet ist, geschmolzen und als flüssiger Film 8 durch das Rohr zum wachsenden Einkristall geleitet wird. Geschmolzenes Granulat kann auch bereits zum Kristallisieren des konusförmig erweiterten Abschnitts des Einkristalls verwendet werden.

Die zweite Induktionsheizspule ist vorzugsweise so ausgebildet, wie eine in der DE 10 2008 013 326 A1 beschriebene Induktionsheizspule, die über in das konische Rohr 1 hineinragende Segmente 12 verfügt.

In Figur 1 ist die Situation dargestellt, in der bereits der Dünnhals 5 des Einkristalls kristallisiert wurde. Das erste Volumen 9 aus geschmolzenem Silizium befindet sich zwischen dem unteren Ende des dort verschlossenen konischen Rohrs 1 und dem Dünnhals 5.

Gemäß einer ersten Ausführungsform des Verfahrens wird ein zweites Volumen 10 aus geschmolzenem Silizium im verschlossenen konischen Rohr 1 erzeugt, indem die obere Seite der sich drehenden Platte 3 und die Innenwand des konischen Rohrs 1 mit Hilfe der zweiten Induktionsheizspule 7 geschmolzen werden. Das zweite Volumen 10 aus geschmolzenem Silizium staut sich im unteren Ende des konischen Rohrs auf. Es kann zu diesem Zeitpunkt auch bereits geschmolzenes Silizium enthalten, das von Granulat 6 stammt, das durch einen oder mehrere Trichter 11 und eine entsprechende Anzahl von Öffnungen in der zweiten Induktionsheizspule 7 auf die sich drehende Platte 3 gefördert und anschließend mit Hilfe der zweiten Induktionsheizspule 7 geschmolzen wurde.

Das untere Ende des konischen Rohrs 1 wird mit Hilfe der ersten Induktionsheizspule 2 weiter geschmolzen, bis der Teil des unteren Endes des konischen Rohrs, der das konische Rohr 1 an dessen unterem Ende verschließt, vollständig geschmolzen ist. Dadurch wird eine Durchtrittsöffnung im konischen Rohr 1 geschaffen, durch die das im Rohr aufgestaute zweite Volumen 10 aus geschmolzenem Silizium nahezu augenblicklich in das erste Volumen 9 aus geschmolzenem Silizium fließt. Es ist bevorzugt, das Schaffen der Durchtrittsöffnung zu unterstützen, indem die in das Rohr ragenden Segmente 12 der zweiten Induktionsheizspule 7 auf einen kürzeren Abstand zur Innenwand des Rohrs vorübergehend abgesenkt werden, bis die Durchtrittsöffnung entstanden ist.

Gemäß der ersten Ausführungsform des Verfahrens wird die Durchtrittsöffnung zu einem Zeitpunkt geschaffen, zu dem das zweite Volumen 10 aus geschmolzenem Silizium kleiner als das doppelte Volumen des ersten Volumens 9 aus geschmolzenem Silizium ist. In diesem Fall wird das empfindliche System, das der wachsende Einkristall darstellt, nur geringfügig gestört, so dass die Wahrscheinlichkeit gering ist, dass Versetzungen gebildet werden oder geschmolzenes Silizium der vereinigten Schmelzenvolumina über den Rand der Grenzfläche hinaus am wachsenden Einkristalls abläuft.

Gemäß einer zweiten Ausführungsform des Verfahrens wird die Durchtrittsöffnung im konischen Rohr 1 zu einem Zeitpunkt geschaffen, zu dem noch kein zweites Volumen 10 aus geschmolzenem Silizium im konischen Rohr vorhanden ist. In diesem Fall wird erst dann damit begonnen, Silizium mit Hilfe der zweiten Induktionsheizspule 7 zu schmelzen, nachdem die Durchtrittsöffnung im konischen Rohr geschaffen wurde. Auch bei dieser Vorgehensweise bleiben damit verbundene Störungen des wachsenden Einkristalls in einem unerheblichen Umfang.

## Patentansprüche

1. Verfahren zur Herstellung eines Einkristalls aus Silizium unter Verwendung von geschmolzenem Granulat, umfassend das Erzeugen eines ersten Volumens aus geschmolzenem Silizium zwischen einem wachsenden Einkristall und dem unteren Ende eines am unteren Ende verschlossenen konischen Rohrs aus Silizium, das eine zentrale Öffnung einer sich drehenden Platte aus Silizium umschließt, unter die sich das Rohr erstreckt, mittels einer ersten Induktionsheizspule, die unter der Platte angeordnet ist;
das Erzeugen eines zweiten Volumens aus geschmolzenem Silizium mit Hilfe einer zweiten Induktionsheizspule, die über der Platte angeordnet ist;
das Schmelzen des unteren Endes des Rohrs in einem Ausmaß, dass eine Durchtrittsöffnung für das zweite Volumen von geschmolzenem Silizium geschaffen wird, wobei die Durchtrittsöffnung zu einem Zeitpunkt geschaffen wird, zu dem das zweite Volumen aus geschmolzenem Silizium kleiner als das doppelte Volumen des ersten Volumens aus geschmolzenem Silizium ist; und
das Kristallisieren von einkristallinem Silizium auf dem wachsenden Einkristall unter Verbrauch von geschmolzenem Silizium aus dem ersten und dem zweiten Volumen.

2. Verfahren nach Anspruch 1, umfassend das Unterstützen des Schaffens der Durchtrittsöffnung durch Absenken von in das Rohr ragenden Segmenten der zweiten Induktionsheizspule.

3. Verfahren nach Anspruch 1 oder Anspruch 2, umfassend das Erzeugen eines Teils des zweiten Volumens aus geschmolzenem Silizium durch Schmelzen von Silizium von einer oberen Seite der Platte und von einer Innenwand des Rohrs.

4. Verfahren nach einem der Ansprüche 1 bis 3, umfassend das Beginnen des Schmelzens von zur Platte gefördertem Granulat, während oder nachdem ein konusförmig erweiterter Abschnitt des Einkristalls kristallisiert wurde.

## Claims

1. Method for producing a single crystal composed of silicon using molten granules, comprising producing a first volume of molten silicon between a growing single crystal and the lower end of a conical tube composed of silicon, which tube is closed off at the lower end and encloses a central opening of a rotating plate composed of silicon, below which the tube extends, by means of a first induction heating coil, which is arranged below the plate;
producing a second volume of molten silicon with the aid of a second induction heating coil, which is arranged above the plate;
melting the lower end of the tube to an extent such that a passage opening for the second volume of molten silicon is produced, the passage opening being produced at a point in time at which the second volume of molten silicon is less than double the volume of the first volume of molten silicon; and
crystallizing monocrystalline silicon on the growing single crystal with consumption of molten silicon from the first and the second volume.

2. Method according to Claim 1, comprising supporting the production of the passage opening by lowering segments of the second induction heating coil which project into the tube.

3. Method according to Claim 1 or Claim 2, comprising producing a part of the second volume of molten silicon by melting silicon from an upper side of the plate and from an inner wall of the tube.

4. Method according to any of Claims 1 to 3, comprising beginning the melting of granules conveyed to the plate during or after crystallization of a conically extended section of the single crystal.

## Revendications

1. Procédé de fabrication d'un monocristal de silicium par recours à un granulé fondu, le procédé comportant la formation d'un premier volume de silicium fondu entre un monocristal en croissance et l'extrémité inférieure d'un tube conique en silicium fermé à son extrémité inférieure et qui entoure une ouverture centrale d'une plaque de silicium en rotation en dessous de laquelle le tube s'étend, et ce au moyen d'une première bobine de chauffage à induction disposée en dessous de la plaque,
le chauffage d'un deuxième volume de silicium fondu à l'aide d'une deuxième bobine de chauffage à induction disposée au-dessus de la plaque,
la fusion de l'extrémité inférieure du tube dans une mesure telle qu'une ouverture de passage pour le deuxième volume de silicium fondu soit formée, l'ouverture de passage étant formée à un instant auquel le deuxième volume de silicium fondu est inférieur au double du premier volume de silicium fondu et
la cristallisation de silicium monocristallin sur le monocristal en croissance en consommant le silicium fondu provenant du premier et du deuxième volume.

2. Procédé selon la revendication 1, comprenant le soutien de la formation de l'ouverture de passage par abaissement de segments de la deuxième bobine de chauffage par induction qui pénètrent dans le tube.

3. Procédé selon la revendication 1 ou la revendication 2, comprenant la formation d'une partie du deuxième volume de silicium fondu par fusion du silicium du côté supérieur de la plaque et de la paroi intérieure du tube.

4. Procédé selon l'une des revendications 1 à 3, comprenant le lancement de la fusion de granulés transportés vers la plaque pendant ou après qu'une partie du monocristal évasée en forme de cône a cristallisé.
